(19) Europäisches Patentamt
European Patent Office
Office européen des brevets

(11) **EP 1 875 524 B1**

(12) **EUROPEAN PATENT SPECIFICATION**

(45) Date of publication and mention
of the grant of the patent:
**26.06.2013 Bulletin 2013/26**

(51) Int Cl.:
*H01L 35/26* *(2006.01)*    *H01L 35/32* *(2006.01)*
*H01L 35/34* *(2006.01)*

(21) Application number: **06751778.9**

(22) Date of filing: **27.04.2006**

(86) International application number:
**PCT/US2006/016257**

(87) International publication number:
**WO 2006/116690 (02.11.2006 Gazette 2006/44)**

(54) **MOLDABLE PELTIER THERMAL TRANSFER DEVICE AND METHOD OF MANUFACTURING SAME**

FORMBARE PELTIER-WÄRMETRANSFEREINRICHTUNG UND HERSTELLUNGSVERFAHREN DAFÜR

DISPOSITIF DE TRANSFERT THERMIQUE PELTIER MOULABLE ET PROCEDE DE FABRICATION ASSOCIE

(84) Designated Contracting States:
**AT BE BG CH CY CZ DE DK EE ES FI FR GB GR HU IE IS IT LI LT LU LV MC NL PL PT RO SE SI SK TR**

(30) Priority: **28.04.2005 US 675786 P**
**26.04.2006 US 380300**

(43) Date of publication of application:
**09.01.2008 Bulletin 2008/02**

(73) Proprietor: **Cool Shield, Inc.**
**Warwick RI 02886 (US)**

(72) Inventor: **MCCULLOUGH, Kevin, A.**
**North Kingstown, Rhode Island 02852 (US)**

(74) Representative: **Hofstetter, Schurack & Partner**
**Patent- und Rechtsanwaltskanzlei**
**Partnerschaft**
**Balanstrasse 57**
**81541 München (DE)**

(56) References cited:
EP-A- 1 187 230         GB-A- 952 678
GB-A- 2 113 914         JP-A- 7 283 442
JP-A- 2002 353 521      US-A- 3 256 700
US-A- 3 859 143         US-A- 5 324 377
US-A- 6 043 424         US-A1- 2002 170 590
US-A1- 2003 219 933     US-A1- 2004 150 011
US-A1- 2004 206 991     US-A1- 2004 261 830
US-A1- 2005 012 204     US-A1- 2005 029 009
US-A1- 2005 284 512     US-B1- 6 313 392

US-B1- 6 593 255

• GUERRERO V H ET AL: "Thermoelectric property tailoring by composite engineering" JOURNAL OF MATERIALS SCIENCE KLUWER ACADEMIC PUBLISHERS USA, vol. 37, no. 19, 1 October 2002 (2002-10-01), pages 4127-4136, XP002505017 ISSN: 0022-2461

• HOHYUN LEE ET AL: "Thermoelectric properties of Si/Ge nano-composite" THERMOELECTRICS, 2005. ICT 2005. 24TH INTERNATIONAL CONFERENCE ON CLEMSEN, SC, USA 19-23 JUNE 2005, PISCATAWAY, NJ, USA,IEEE, 19 June 2005 (2005-06-19), pages 269-271, XP010842911 ISBN: 978-0-7803-9552-7

• ZHAO X ET AL: "Bismuth telluride nanotubes and the effects on the thermoelectric properties of nanotube-containing nanocomposites", APPLIED PHYSICS LETTERS, AIP, AMERICAN INSTITUTE OF PHYSICS, MELVILLE, NY, US, vol. 86, no. 6, 3 February 2005 (2005-02-03), pages 62111-062111, XP012066267, ISSN: 0003-6951, DOI: DOI:10.1063/1.1863440

Remarks:
The file contains technical information submitted after the application was filed and not included in this specification

## Description

BACKGROUND OF THE INVENTION

The present invention generally relates to devices for use in transferring or dissipating heat for purposes of thermal management. Moreover, the present invention relates to using such devices to cool parts and components, such as those in a computer system, so those parts do not fail over time. The present invention relates specifically to solid state heat transfer devices for these purposes.

In the prior art, there are many different types devices that can be used for thermal management, such as for cooling objects. These devices have particular application, for example, in thermal management within a computer environment. Typical thermal solutions include finned heat sinks and mechanical fans for cooling parts that run hot. However, these solutions can be expensive and inefficient.

There are also a need for devices for use as sources of heat for various applications. For example, a hot plate may be used for heating a car seat or for raising the temperature of mechanical component for better operation thereof. These solutions have typically been coils with hot water therein or resistive wire that heat up when electricity is passed therethrough. However, these methods are expensive and inefficient.

There have been attempts in the prior art to provide a solid state replacement for the aforementioned mechanical thermal solutions by using materials that exploit the Peltier effect. The Peltier effect is the creation of a heat difference from an electric voltage. More specifically, it occurs when a current is passed through two dissimilar metals or semiconductors, for example n-type and p-type material, that are connected to each other at two junctions, known as Peltier junctions. The current drives a transfer of heat from one junction to the other where one junction cools off while the other heats up.

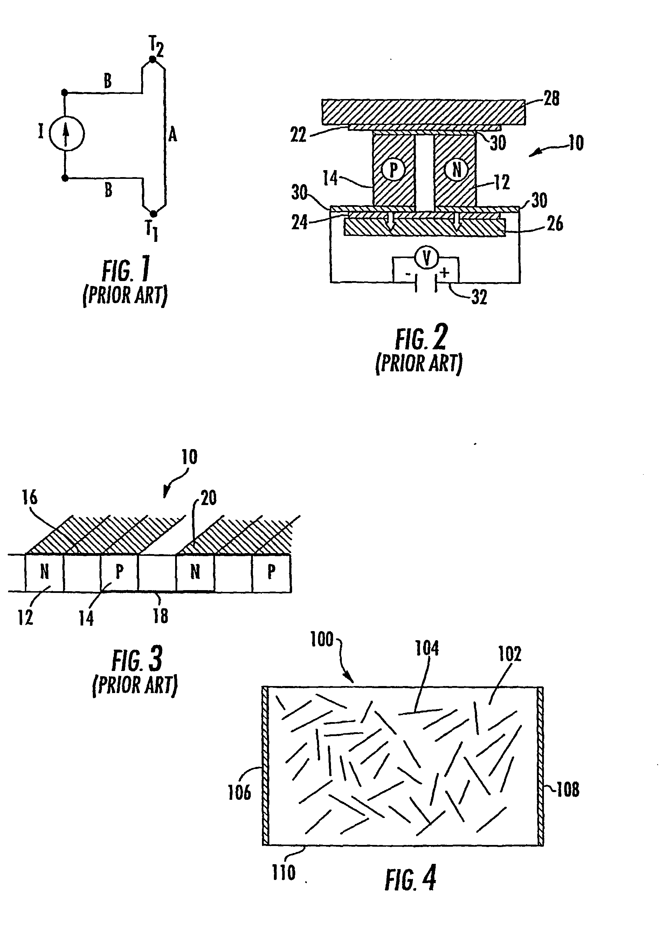

Referring to the circuit diagram of prior art Fig. 1, when a current I is made to flow through the circuit, heat is evolved at the upper junction (at $T_2$), and absorbed at the lower junction (at $T_1$). The Peltier heat absorbed by the lower **junction** per unit time, $Q$ is equal to:

$$\dot{Q} = \Pi_{AB}I = (\Pi_B - \Pi_A)\,I$$

Where $\Pi$ is the Peltier coefficient $\Pi_{AB}$ of the entire thermocouple, and $\Pi_A$ and $\Pi_B$ are the coefficients of each material. P-type silicon typically has a positive Peltier coefficient, which is typically not above approximately 550 K while n-type silicon is typically negative.

In this Peltier effect, the conductors are attempting to return to the electron equilibrium that existed before the current was applied by absorbing energy at one connector and releasing it at the other. The individual couples can be connected in series to enhance the Peltier effect. The direction of heat transfer is controlled by the polarity of the current, reversing the polarity will change the direction of transfer and thus the sign of the heat absorbed/evolved.

There have been attempts in the prior art to exploit the Peltier effect for cooling and heating purposes. For example, a Peltier cooler/heater or thermoelectric heat pumps are well known, which are solid-state active heat pumps which transfer heat from one side of the device to the other. Peltier coolers are also called TECs (Thermo Electric Converter). These prior art solid state Peltier devices are plate-like in configuration and typically include an alternating array of P-type and N-type materials.

For example, a thermoelectric module 10, shown in Fig. 2, is an example of such a prior art Peltier device where only one P-N junction is shown for explanatory purposes. A typical thermoelectric module 10 is manufactured using two thin ceramic wafers 22, 24 with a series of N-type 12 and P-type 14 and semiconductor material, such as bismuth-telluride doped material, sandwiched between them. Electrical contacts 30 are also provided to deliver current from the power source 32. The ceramic material 22, 24 on both sides of the thermoelectric adds rigidity and the necessary electrical insulation from the heat sink 26 and the object 28 to be cooled. The N-type 12 material has an excess of electrons, while the P-type 14 material has a deficit of electrons. One N-type 12 and P-type 14 one make up a couple 34, as shown in prior art Fig. 2.

Thermoelectric couples 34 are arranged electrically in series and thermally in parallel. A thermoelectric module 10 can contain one to several hundred couples, for example. Prior art Fig. 3 shows an example of a prior art thermocouple device 10 that includes an array of P-type material and N-type material in arranged in series. The N-type material 12 and P-type material 14 are specifically arranged in alternating rows where electrodes 16, 18 and 20 are provided in alternating fashion to connect the materials in series to create a string of N-P, P-N and N-P interfaces, and so on. In the device of Fig. 3, the electrodes 16 and 20 are positioned on the top of the plate while electrode 18 is positioned on the bottom of the plate. Typical insulative layers are not shown in Fig. 3 for clarity of illustration. This arrangement ensures that current flows from electrode 16 to 18 and then to 18. Large numbers of these plates can be stacked together with the appropriate dielectric insulative material therebetween, as described above.

While these prior art thermocouples may be useful in certain environments, they are only approximately 10% efficient because the joule heat and thermal backlash. Thus, in the prior art devices, a very low thermally conductive material must be used to prevent this thermal backlash. These prior art devices also suffer from the disadvantage that is it difficult and expensive to manufacture and is limited in its configuration to specific and precise alternating rows of N-type and P-type materials with precisely positioned alternating leads. Thus, the applications for such plate-like devices are limited to such applications that can accommodate cooling devices of such a configuration. As a result, they cannot be easily formed into different shapes and configuration for using in different types of applications that require a cooling device that is not of a plate shape.

Therefore, there is a need for a Peltier type device that can be formed in any type of shape or configuration that is more efficient than prior art devices while still being able to serve as a cooling or heating device for thermal management. US-A-3 256 700 discloses thermoelectric elements and a process for manufacture thereof. Thereby a stable compound or a combination of compounds of the group of certain oxides is dispersed within a thermoelectric matrix material, wherein the material is characterized by a large Seebeck coefficient and a negative coefficient of resistivity. V. H. Guerrero et al. discloses in an article "Thermoelectric property tailoring by composite engineering" (In: Journal of material science, 37 (2002), 4127-4136) thermoelectric structural composites including carbon fiber polymer-matrix composites and short fiber cement-matrix composites.

## SUMMARY OF THE INVENTION

The present invention preserves the advantages of prior art thermal transfer devices. In addition, it provides new advantages not found in currently available devices and overcomes many disadvantages of such currently available devices.

The invention is defined in claims 1 and 6 and is generally directed to the novel and unique thermal transfer device, which includes a body member having a base material of a first semiconductor material of a first conductivity type with a filler material having an aspect ratio of 5:1 or greater dispersed therein of a second semiconductor material of a second conductivity type. Electrodes are attached on sides of the body member and electrical current is run therethrough to create thermal flow using the Peltier effect. As stated above, the direction of the current flow dictates whether the device cools or heats. The device is formed by injection molding and the like and the filler is introduced into the base by, for example, extrusion or pultrusion processes.

It is therefore an object of the present invention to provide a thermal transfer device that is easily moldable into any shape, size and configuration. It is an object of the present invention to provide a thermal transfer device that employs the Peltier effect and is moldable, such as by injection molding. Another object of the present invention is to provide a thermal transfer device where the thermal flow is controlled. A further object is to provide a Peltier thermal transfer device that is not limited to a plate shape and configuration.

## BRIEF DESCRIPTION OF THE DRAWINGS

The novel features which are characteristic of the present invention are set forth in the appended claims. However, the invention's preferred embodiments, together with further objects and attendant advantages, will be best understood by reference to the following detailed description taken in connection with the accompanying drawings in which:

Fig. 1 is a prior art circuit diagram illustrating the Peltier effect;

Fig. 2 is an elevational view of a prior art thermocouple employing the Peltier effect;

Fig. 3 is front perspective view of a prior art arrangement of multiple thermocouples arranged in series; and

Fig. 4 is a cross-sectional view of a thermocouple device in accordance with the present invention.

## DETAILED DESCRIPTION OF THE PREFERRED EMBODIMENT

The present invention solves the problems in the prior art by providing a new and unique Peltier thermocouple device that can be formed into a wide array of shapes, sizes and configuration and is more efficient than prior art Peltier thermocouple devices. The device of the present invention can be injection molded so it can be used in a wide range of thermal management applications thereby avoiding the limitation of prior art devices that are of a plate-shaped configuration.

As shown in Fig. 4, the device 100 present invention includes a base material 102 with filler 104 with electrodes 106 and 108 disposed on opposing ends thereof. In general, the device of the present invention provides a moldable base material of a first type of semiconductor material that is filled with a second type of semiconductor material.

More specifically, in accordance with the present invention, the base material 102 can be either an N-type or P-type material while the filler material is of the opposite type of the base material. For example, if the base material is selected to be an N-type material, then the filler material is selected to be P-type in nature. The materials can be any type of compatible N-type or P-type material. For example, the base and filler can be appropriately doped with bismuth to created the desired N-type and P-type semiconductor material. The filler material is of a high aspect ratio (such as 5:1 or higher) to improve electrically interconnection through the body.

In accordance with the present invention, the P-type material and N-type material can be any suitable material. Commonly used semiconducting materials can be used, such as silicon, germanium, gallium arsenide and indium phosphide. It should be understood that the present invention is in no way limited to use of these materials only. To achieve an N-type material, a semiconductor material is doped with the appropriate element, such as antimony. To achieve a P-type material, the semiconductor material is doped with the appropriate element, such as boron. Semiconductor materials and the doping thereof to achieve N-type and P-type materials are so well known in the art that they need not be discussed in further detail herein.

The device 100 is shown to be of a block configuration for ease of illustration. However, as will be described below, the material is easily formable into different shapes and configurations because it is moldable, such as by injection molding. Across the body of the molded member, generally referred to as 110, of base material 102 and filler 104, shown in Fig. 4, electricity passes therethrough, namely through alternating filler material 104 and base material 102, namely alternating N-type and P-type material, from electrode 106 to electrode 108. Depending on the loading of the base material 102 with filler material 104, there can be dozens if not hundreds of P-N interfaces and, therefore, resultant P-N junctions than can employ the Peltier effect.

The base material 102 is preferably of a higher electrical resistance to ensure flow of electricity through the filler 104 dispersed therein. Thus, the Peltier effect of N-P-N-P junctions can be reproduced effectively in the composite molded device of the present invention. Heat propagates across the body 110 of the device from the negative (-) side to the positive (+) side as in all Peltier devices. In the device of Fig. 4, as above, the direction of current flow will dictate the direction of thermal flow.

Known methods of injection molding material and introducing filler therein can be used to carry out the present invention. For example, pellets of N-type base material filled with P-type material filler or P-type base material filled with N-type material filler can be introduced into an injection molding machine for introduction into an injection mold having a cavity that defines a desired net shape for the cooling device. Alternatively, semiconductor material of a first type can be introduced into an injection molding machine while semiconductor material of a second type is introduced by an extrusion or pultrusion process. These processes are so well known in the art that they need not be discussed in further detail herein.

As a specific example showing the effectiveness of the present invention, a base material of Bismuth (an N-type material) was loaded about 30% with Tellurium (a P-type material) and formed into a body with the approximate dimensions of 3.8 cm (1.5 inch) long 1.3 cm (0.5 inch) wide and 0.6 cm (0.25 inch) high. The Tellurium was not melted or alloyed with the Bismuth. Electricity of 1 volt at 2 amps was run through the body. It was measured that the body exhibited a temperature of 10°C below ambient temperature. As a result, formed body acted as a cooler employing the Peltier effect.

For example, the composition of the present invention can be formed into the configuration of a heat sink assembly where the body of the heat sink is net-shape molded into a fin or pin array where the base of the heat sink carries a first electrode while all of the tips of the pins carry a second electrode. The electrode can be affixed onto the molded assembly after molded or directly overmolded, for example.

The electrode on the base of the heat sink can be placed into thermal communication with a heat generating object, such as a microprocessor that is running hot. With the proper polarity of the current through the heat sink body, the object can be cooled where the heat is drawn away from the base of the heat sink and then up through the tips of the pins for optimal thermal transfer and management. Alternatively, the polarity of current flow can be reversed to reverse thermal flow for heating, such as for a car seat.

Therefore, the present invention provides a new and useful Peltier thermocouple device that can be used for thermal management. The new device can be formed using injection molding or other forming techniques to accommodate thermal management needs that cannot be met with prior art technology. The present invention is new and unique because it provides a net-shape moldable, such as by injection molding, composite material into any desired shape where Peltier cooling or heating can be achieved.

**Claims**

1. A thermal transfer device,
   comprising
   a body member having a base material (102) of a first semiconductor material of an N-type or a P-type with a filler material (104) dispersed therein of a second semiconductor material of an N-type or a P-type that is different than the first semiconductor material wherein the first and second semiconductor materials are of an opposite conductivity type; the body member having a first side and a second side;
   a first electrode (106) connected to the first side;
   a second electrode (108) connected to the second side;
   whereby passing electrical current through the body member via the first electrode (106) and the second electrode (108) causes thermal flow through the body member **characterized in that** the filler material (104) has an aspect ratio of 5:1 or greater.

2. The device of claim 1, wherein the base material (102) is manufactured of a P-type semiconductor material.

3. The device of claim 1, wherein the base material (102) is manufactured of an N-type semiconductor material.

4. The device of claim 1, wherein the filler material (104) is manufactured of a P-type semiconductor material.

5. The device of claim 1, wherein the filler material (104) is manufactured of an N-type semiconductor material.

6. A method of manufacturing a thermal transfer device,
   **characterized by** the steps of:

   providing a moldable base material (102) of a first semiconductor material of an N-type or a P-type;
   filling the base material (102) with a filler material (104) of a second semiconductor material of an N-type or a P-type that is different than the first semiconductor material wherein the first and second semiconductor materials are of an opposite conductivity type;
   forming the moldable base material (102), with filler (104) dispersed therein, into a body member having a first side and a second side; ,
   attaching a first electrode (106) to the first side;
   attaching a second electrode (108) connected to the second side; and
   whereby passing electrical current through the body member causes thermal flow through the body member and wherein the filler material (104) has an aspect ratio of 5:1 or greater.

7. The method of claim 6, wherein the base material (102) is manufactured of a P-type semiconductor material.

8. The method of claim 6, wherein the base material (102) is manufactured of an N-type semiconductor material.

9. The method of claim 6, wherein the filler material (104) is manufactured of a P-type semiconductor material.

10. The method of claim 6, wherein the filler material (104) is manufactured of a N-type semiconductor material.

11. The method of claim 6, wherein the base is filled with filler (104) by pultrusion.

12. The method of claim 6, wherein the base is filled with filler (104) by extrusion.

**Patentansprüche**

1. Thermotransfervorrichtung,
   die umfasst
   ein Körperelement mit einem Basismaterial (102) aus einem ersten Halbleitermaterial eines N-Typs oder eines P-Typs mit einem darin dispergierten Füllmaterial (104) aus einem zweiten Halbleitermaterial eines N-Typs oder eines P-Typs, das anders ist als das erste Halbleitermaterial, wobei das erste und das zweite Halbleitermaterial von einem entgegengesetzten Leitfähigkeitstyp sind; wobei das Körperelement eine erste Seite und eine zweite Seite aufweist;
eine erste Elektrode (106), die mit der ersten Seite verbunden ist;
eine zweite Elektrode (108), die mit der zweiten Seite verbunden ist;
wobei das Leiten eines elektrischem Stroms durch das Körperelement über die erste Elektrode (106) und die zweite Elektrode (108) einen Wärmefluss durch das Körperelement bewirkt, **dadurch gekennzeichnet, dass** das Füllmaterial (104) ein Seitenverhältnis von 5:1 oder größer aufweist.

2. Vorrichtung nach Anspruch 1, wobei das Basismaterial (102) aus einem Halbleitermaterial vom P-Typ hergestellt ist.

3. Vorrichtung nach Anspruch 1, wobei das Basismaterial (102) aus einem Halbleitermaterial vom N-Typ hergestellt ist.

4. Vorrichtung nach Anspruch 1, wobei das Füllmaterial (104) aus einem Halbleitermaterial vom P-Typ hergestellt ist.

5. Vorrichtung nach Anspruch 1, wobei das Füllmaterial (104) aus einem Halbleitermaterial vom N-Typ hergestellt ist.

6. Verfahren zur Herstellung einer Thermotransfervorrichtung,
   **gekennzeichnet durch** die Schritte:

   Vorsehen eines formbaren Basismaterials (102) aus einem ersten Halbleitermaterial von einem N-Typ oder einem P-Typ;
   Füllen des Basismaterials (102) mit einem Füllmaterial (104) aus einem zweiten Halbleitermaterial von einem N-Typ oder einem P-Typ, das anders ist als das erste Halbleitermaterial, wobei das erste und das zweite Halbleitermaterial von einem entgegengesetzten Leitfähigkeitstyp sind;
   Ausbilden des formbaren Basismaterials (102) mit dem darin dispergierten Füllstoff (104) zu einem Körperelement mit einer ersten Seite und einer zweiten Seite;
   Befestigen einer ersten Elektrode (106) an der ersten Seite;
   Befestigen einer zweiten Elektrode (108), die mit der zweiten Seite verbunden ist; und
   wobei das Leiten eines elektrischen Stroms **durch** das Körperelement einen Wärmefluss **durch** das Körperelement bewirkt und wobei das Füllmaterial (104) ein Seitenverhältnis von 5:1 oder größer aufweist.

7. Verfahren nach Anspruch 6, wobei das Basismaterial (102) aus einem Halbleitermaterial vom P-Typ hergestellt wird.

8. Verfahren nach Anspruch 6, wobei das Basismaterial (102) aus einem Halbleitermaterial vom N-Typ hergestellt wird.

9. Verfahren nach Anspruch 6, wobei das Füllmaterial (104) aus einem Halbleitermaterial vom P-Typ hergestellt wird.

10. Verfahren nach Anspruch 6, wobei das Füllmaterial (104) aus einem Halbleitermaterial vom N-Typ hergestellt wird.

11. Verfahren nach Anspruch 6, wobei die Basis durch Pultrusion mit dem Füllstoff (104) gefüllt wird.

12. Verfahren nach Anspruch 6, wobei die Basis durch Extrusion mit dem Füllstoff (104) gefüllt wird.

**Revendications**

1. Dispositif de transfert thermique, comprenant
un élément formant corps, ayant un matériau (102) de base d'un premier matériau semi-conducteur de type N ou de type P, avec un matériau (104) de remplissage, dispersé dans celui-ci, d'un second matériau semi-conducteur de type N ou de type P, qui est différent du premier matériau semi-conducteur, dans lequel les premier et second matériaux semi-conducteurs sont d'un type de conductivité opposé ;
l'élément formant corps ayant un premier côté et un second côté ;
une première électrode (106), connectée sur le premier côté ;
une seconde électrode (108), connectée sur le second côté ; moyennant quoi le fait de faire passer du courant électrique dans l'élément formant corps par l'intermédiaire de la première électrode (106) et de la seconde électrode (108) génère un flux thermique dans l'élément formant corps,
**caractérisé en ce que**
le matériau (104) de remplissage a un rapport de format de 5:1 ou plus.

2. Dispositif selon la revendication 1, dans lequel le matériau (102) de base est fabriqué à partir d'un matériau semi-conducteur de type P.

3. Dispositif selon la revendication 1, dans lequel le matériau (102) de base est fabriqué à partir d'un matériau semi-conducteur de type N.

4. Dispositif selon la revendication 1, dans lequel le matériau (104) de remplissage est fabriqué à partir d'un matériau semi-conducteur de type P.

5. Dispositif selon la revendication 1, dans lequel le matériau (104) de remplissage est fabriqué à partir d'un matériau semi-conducteur de type N.

6. Procédé de fabrication d'un dispositif de transfert thermique, **caractérisé par** les étapes, consistant à :

prévoir un matériau (102) de base moulable à partir d'un premier matériau semi-conducteur de type N ou de type P ;
remplir le matériau (102) de base avec un matériau (104) de remplissage d'un second matériau semi-conducteur de type N ou de type P, qui est différent du premier matériau semi-conducteur, dans lequel les premier et second matériaux semi-conducteurs sont d'un type de conductivité opposé ;
former le matériau (102) de base moulable, avec la masse (104) de remplissage dispersée dans celui-ci, dans un élément formant corps, ayant un premier côté et un second côté ;
fixer une première électrode (106) sur le premier côté ;
fixer une seconde électrode (108), connectée sur le second côté et
moyennant quoi le fait de faire passer du courant électrique dans l'élément formant corps génère un flux thermique dans l'élément formant corps et dans lequel le matériau (104) de remplissage a un rapport de format de 5:1 ou plus.

7. Procédé selon la revendication 6, dans lequel le matériau (102) de base est fabriqué à partir d'un matériau semi-conducteur de type P.

8. Procédé selon la revendication 6, dans lequel le matériau (102) de base est fabriqué à partir d'un matériau semi-conducteur de type N.

9. Procédé selon la revendication 6, dans lequel le matériau (104) de remplissage est fabriqué à partir d'un matériau semi-conducteur de type P.

10. Procédé selon la revendication 6, dans lequel le matériau (104) de remplissage est fabriqué à partir d'un matériau semi-conducteur de type N.

11. Procédé selon la revendication 6, dans lequel la base est remplie avec une masse (104) de remplissage par pultrusion.

**12.** Procédé selon la revendication 6, dans lequel la base est remplie avec une masse (104) de remplissage par extrusion.

FIG. 1
(PRIOR ART)

FIG. 2
(PRIOR ART)

FIG. 3
(PRIOR ART)

FIG. 4

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 3256700 A

**Non-patent literature cited in the description**

- **V. H. GUERRERO et al.** Thermoelectric property tailoring by composite engineering. *Journal of material science,* 2002, vol. 37, 4127-4136